# EUROPEAN PATENT APPLICATION

(11) **EP 1 473 834 A1**
(43) Date of publication of application: **03.11.2004**
(21) Application number: 03425273.4
(22) Date of filing: 30.04.2003
(51) Int. Cl.: H03L 7/085, H03L 7/093, H03D 13/00

(54) **Method and circuit for sensing the transition density of a signal and variable gain phase detecting method and device**

(71) Applicant: STMicroelectronics S.r.l., 20041 Agrate Brianza (Milano) (IT)
(72) Inventor: Centurelli, Francesco, 00162 Roma (IT); Pozzoni, Massimo, 27100 Pavia (IT); Scotti, Giuseppe, 04100 Latina (IT); Trifiletti, Alessandro, 00049 Velletri (IT)
(74) Representative: Pellegri, Alberto

(57) **Abstract**

A linear phase detection (PD) has a variable gain that is regulated in function of the monitored transition density of the input signal (DAT).

The transition density is sensed by a circuit (Q3', Q4', R2, C2, Ipd) that generates a signal (V2) corresponding to a time averaged common mode component of the differential current signal (OUT+, OUT-) output by the phase detector (PD).

## Description

### FIELD OF THE INVENTION

The present invention relates in general to linear phase detectors that generate a differential signal representing the phase difference between two input signals.

### BACKGROUND OF THE INVENTION

In long distance transmission systems operating at high bit rates over standard signal fiber lines, data receivers may receive significantly distorted signals. Intersymbolic interference, finite bandwidth, fiber nonlinearity and other non-idealities increase the probability of erroneous recognition of a received bit. For these reasons, it is often necessary to place, along the transmission line, data regenerating channel systems that sample a received signal and retransmit it to either a successive data regenerating system or to the end receiver.

The incoming data at the receiver may be considered as a varying analog signal from which a synchronism or clock signal may be recovered. Recovering the clock in the form of a signal that generally oscillates between a higher level and a lower level signal from the incoming signal is essential for sampling it correctly to regenerate the digital data to be transmitted.

Of course, the clock signal could alternatively be transmitted together with the data stream and the clock be easily filtered at the receiver, in the majority of cases though it must be recovered from the data stream, commonly by the use of a so-called phase locked loop (PLL).

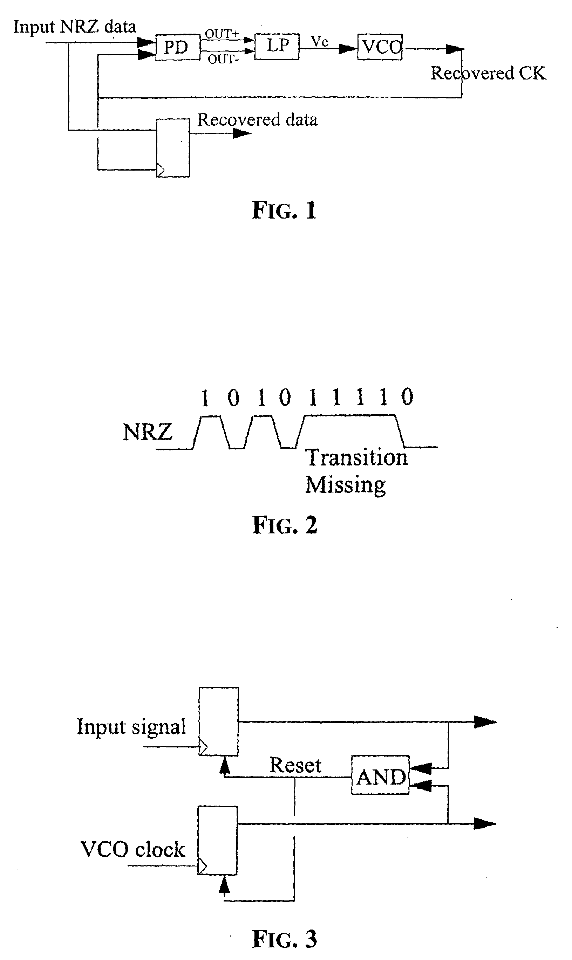

Figure 1 shows a sample architecture of a system for data regeneration. It is substantially composed of a phase-locked loop, which includes a phase detector PD, a loop filter LP and a voltage controlled oscillator VCO. The loop recovers the clock signal CK and provides it to a D-type flip-flop that samples the input signal for outputting a regenerated data stream.

The phase detector PD is input with the digital signal DAT to be regenerated and retransmitted and the recovered clock CK, and commonly includes a differential stage that outputs a differential signal OUT+, OUT- representing the phase difference between the digital signal DAT and the clock CK. This differential signal is produced by comparing the transition edges of the digital signal and of the clock signal.

The loop filter LP is input with the differential signal OUT+, OUT- and generates a control voltage Vc of a voltage controlled oscillator VCO by low pass filtering the differential component of the differential signal OUT+, OUT-. If the control voltage Vc is not null, the VCO adjusts the frequency of the so recovered clock CK until the control voltage becomes null.

If the digital signal DAT switches regularly, the phase detector is able to continuously compare the transition edges of the recovered clock and of the signal DAT and thus the recovered clock has a good precision. Differently, when the digital signal is a so-called Non-Return to Zero (NRZ) signal, such as the one depicted in Figure 2, there may not be transitions for a relatively long time, and during those intervals the PLL loop is no longer able to adjust the frequency of the recovered clock.

Many types of phase detectors are available. Among the most diffused ones, it is worth mentioning the classical phase and frequency detector (PFD), the "bang-bang" detector and the linear phase detector.

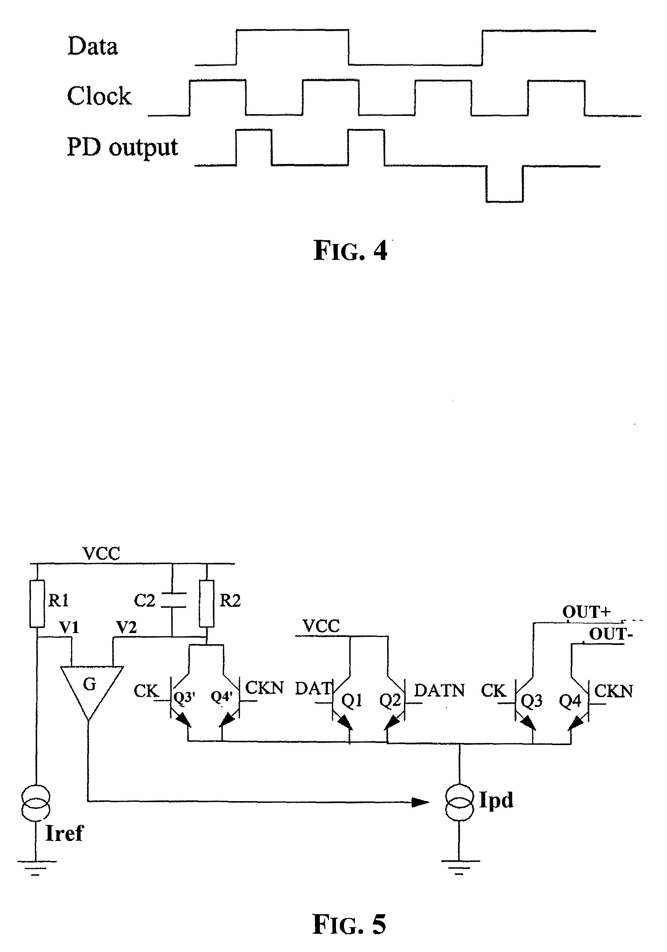

The PFD detector, shown in Figure 3, is most commonly used in PLL systems because of its capability of detecting both phase and frequency errors. It comprises two D-type flip-flops, the first clocked by the input signal and the second by the recovered clock generated by the voltage controlled oscillator VCO of the phase-locked loop. When one of these signals undergo a transition, the output of the respective flip-flop is set. The two flip-flops may be reset only when both are set.

In this mode the flip-flops generate two output pulses, and the difference between the duration of these two pulses represents the phase error between the two input signals.

The advantage of this detector consists in its capability of sensing both phase errors and frequency errors and in the fact that its output is proportional to the phase mismatch. A second advantage consists in the fact that when the two inputs are synchronized, the duration of the output pulses is null and there is no injection into the loop filter and, as a consequence, a minimized jitter.

A disadvantage of this architecture is that it does not work in case of absence of transitions in the input signal and so it is not usable for regenerating data of a NRZ transmission system.

A possible solution to overcome this limitation is represented by the so-called "bang-bang" phase detector, the working principle of which is illustrated by the time diagram of Figure 4.

If a data transition occurs before a clock transition, then this phase detector outputs a fixed-length positive pulse to the loop filter in cascade, while in the opposite case, that is when a data transition occurs after the clock transition, a negative fixed-length pulse value is generated.

The disadvantage of this phase detector consists in the fact that its output is not proportional to the phase error between data and clock, i.e. this phase detector has a non-linear transfer function. A system for regenerating data that employs a bang-bang phase detector may continuously oscillate between a phase lead and a phase lag, increasing the frequency jitter of the recovered clock.

Another family of phase detectors is represented by the linear phase detectors like the Hogge phase detectors, that generate a signal proportional to the phase difference of their input signals. Both linear and bang-bang phase detectors exploit a similar working principle: at the transition of the incoming data, a positive or negative current or voltage pulse is output toward the loop filter, depending on the fact that the data lead or lag the clock. The amplitude of the pulse may be constant (bang-bang phase detectors) or proportional (linear phase detectors) to the phase difference between the data and the clock [1]. Unfortunately, it is very difficult to use them when the data rate is relatively high because they are based on the use of flip-flops, which require a certain time for generating a stable output.
[1] Aaron, Buchwald, Ken, Martin, "Integrated Fiber-Optic Receivers", Kluwer Academic Publishers.

Linear phase detectors based on the use of analog differential stages are intrinsically fast. The differential current signal OUT+, OUT- output by a linear phase detector PD to be fed to the low pass loop filter LP that outputs the control voltage Vc of the VCO, has an amplitude that depends on the gain of the phase detector circuit PD.

The amount of charge that is injected in the low pass loop filter LP in presence of a phase difference between the generally oscillating input signal DAT and the recovered clock signal CK will be determined by the phase difference and by the gain of the phase detector. If the phase detector PD is called to function at markedly different bit rates and/or with MRZ signals, it becomes difficult to optimize the gain at the design stage if the contemplated working frequencies may vary within a broad range.

### OBJECT AND SUMMARY OF THE INVENTION

It has now been found that remarkable improvements in performances of a PLL loop may be achieved by employing a linear phase detector having a variable gain that is made to depend on the transition density of the generally oscillating input signal.

Main objects of this invention are a method and a relative sensing circuit for monitoring the density of transitions of a generally oscillating signal input to a phase detector having an output differential stage that generates a differential current signal (OUT+, OUT-) representative of the phase difference between the oscillating signal (DAT) and a clock signal (CK) applied to a second input of the phase detector, by generating a signal representative of the density of transitions of the oscillating input signal in function of a time averaged common mode component of the differential current signal output by the phase detector.

In other words, the linear phase detector of this invention is effectively auto-adaptive to a varying density of transitions of the input digital signal.

The invention is more precisely defined in the annexed claims.

### BRIEF DESCRIPTION OF THE DRAWINGS

The different aspects and advantages of the invention will appear even more evident through a detailed description of an embodiment and by referring to the attached drawings, wherein:
**Figure 1** illustrates a typical system for regenerating digital data;
**Figure 2** is a sample waveform of a Non-Return-to-Zero digital signal;
**Figure 3** depicts a phase and frequency detector PFD;
**Figure 4** shows the signal waveforms of a "bang-bang" phase detector;
**Figure 5** depicts a preferred embodiment of the phase detector of the invention.

### DESCRIPTION OF DIFFERENT EMBODIMENTS OF THE INVENTION

A sample embodiment of a variable gain linear phase detector of this invention is depicted in Figure 5.

The phase detector is composed of a first differential pair Q3 - Q4, controlled by the clock CK and by its inverted replica CKN, outputting the differential current signal OUT+, OUT-, a second differential pair Q1 - Q2, controlled by the digital input signal DAT and by its inverted replica DATN, the two differential pairs being biased by a common current generator Ipd, the current of which is regulated by a feedback loop to vary the gain of the output differential stage Q3 - Q4, according to this invention.

The regulation loop is implemented by adding a third differential pair of transistors Q3' - Q4' that may be identical or scaled replicas of the transistors Q3 - Q4 of the first (output) differential pair and similarly driven by CK and CKN, such that the currents flowing in the transistors Q3' and Q4' are equal or proportional to the currents flowing in the corresponding output transistors Q3 - Q4 of the first differential pair.

Therefore, through the scaled replica pair Q3' and Q4', will flow common mode currents that will be scaled replicas of the common mode currents present in the output differential pair Q3- Q4 of the phase detector.

The output common mode current flowing in the differential pair Q3' - Q4' is forced through a low pass filter R2 - C2, for generating a voltage V2 representative of a scaled time average of the output common mode current of the phase detector and thus of a measure of the density of transitions of the input digital signal DAT .

The voltage V2 is applied to a first input of an error amplifier G, to the other input of which is applied a reference voltage V1, that may be obtained by forcing a reference current Iref through a resistor R1.

Finally, the error amplifier G regulates the current Ipd generated by the common bias generator of all three differential pairs to make V2 equal V1, according to a feed back control mode.

In presence of intervals of time during which the input digital signal DAT ceases to switch, the voltage V2 on the low-pass filter R2 - C2 decreases, signaling that the time average of the common mode current forced through the filter is diminishing. The high gain differential error amplifier G input with the voltages V1 and V2 will therefore regulate the current Ipd that biases all three differential pairs of transistors to make null the difference between V2 and V1.

When transitions in the digital input signal DAT resume after a long sequence of substantially equal input values (e.g. in a NRZ signal), the transistors Q3 and Q4 of the first differential pair result biased with a relatively enhanced bias current and the gain of the differential stage will be at a correspondingly enhanced level.

This will determine a correspondingly higher level of the control voltage Vc output by the low pass loop filter LP of the PLL (re. Fig. 1), causing a faster reaction of the PLL in recovering a possibly lost synchronism.

## Claims

1. A method of monitoring the transition density of a generally oscillating signal (DAT) input to a phase detector including a differential stage that generates a differential current signal (OUT+, OUT-) representing the phase difference between the oscillating signal (DAT) and a clock signal (CK) input to the phase detector, comprising the step of generating a signal (V2) representative of the transition density of said oscillating signal (DAT) in function of a time averaged common mode component of said differential signal (OUT+, OUT-).

2. A method of generating a differential current signal (OUT+, OUT-) representing the phase difference between a generally oscillating signal (DAT) and a clock signal (CK) applied to respective inputs of a phase detector including a differential stage generating said differential signal (OUT+, OUT-), comprising the steps of
generating a signal (V2) representative of the transition density of said oscillating signal (DAT) according to claim 1;
regulating the gain of said differential stage to make said representative signal (V2) equal to a reference value (V1).

3. A sensing circuit for monitoring the transition density of a generally oscillating signal (DAT) input to a phase detector including a differential stage that generates a differential current signal (OUT+, OUT-) representing the phase difference between the oscillating signal (DAT) and a clock signal (CK) input to the phase detector, generating a signal (V2) representative of the transition density of said oscillating signal (DAT) in function of a time averaged common mode component of said differential signal (OUT+, OUT-).

4. A phase detector including a differential stage that generates a differential current signal (OUT+, OUT-) representing the phase difference between a generally oscillating signal (DAT) and a clock signal (CK) input to the phase detector, having a feedback loop for regulating said bias current generator comprising
a sensing circuit (SENSE) of claim 3 generating a signal (V2) representative of the transition density of said oscillating signal (DAT), and
a correction circuit including an error amplifier of the difference between said signal (V2) and a reference value (V1) regulating the gain of said differential stage to make null said difference.
